# EUROPEAN PATENT APPLICATION

(11) **EP 2 717 310 A1**
(43) Date of publication of application: **09.04.2014**
(21) Application number: 12792472.8
(22) Date of filing: 05.04.2012
(51) Int. Cl.: H01L 23/12, H01L 23/36, H05K 1/09

(54) **SEMICONDUCTOR DEVICE AND WIRING SUBSTRATE**

(30) Priority: 01.06.2011 JP 2011123277
(71) Applicant: Sumitomo Electric Industries, Ltd., Chuo-ku Osaka-shi Osaka 541-0041 (JP)
(72) Inventor: SUGIMURA Takahiro, Osaka-shi Osaka 554-0024 (JP); TSUNO Takashi, Osaka-shi Osaka 554-0024 (JP)
(74) Representative: Grünecker, Kinkeldey, Stockmair & Schwanhäusser
(86) International application number: PCT/JP2012/059406
(87) International publication number: WO 2012/165045

(57) **Abstract**

A semiconductor device (10) according to an embodiment includes an insulating substrate (121), a wiring layer (122) formed on a first main surface (121a) of the insulating substrate, and a semiconductor element (14) mounted on the wiring layer. In this semiconductor device, the wiring layer includes a first copper-containing material containing copper and a metal having the thermal expansion coefficient smaller than that of copper and the thermal expansion coefficient of the first copper-containing material is smaller than that of copper.

## Description

### Technical Field

The present invention relates to a semiconductor device and a wiring substrate.

### Background Art

As an example of a semiconductor device, there is known a semiconductor device including a wiring substrate and a semiconductor element mounted on the wiring substrate (see non patent literature 1). As the above-mentioned wiring substrate, a DBC (Direct Bonding Copper) substrate having a sandwich structure is adopted, in which a ceramic substrate is sandwiched by a copper wire and a heat dissipating layer containing copper. The semiconductor element is soldered and fixed onto the copper wire of the wiring substrate and an electrode of the upper part (on the opposite side of an insulating substrate) of the semiconductor element and the copper wire are electrically connected by an aluminum wire or the like. To the copper wire, a terminal for external connection is soldered and by this terminal, the semiconductor device is driven.

### Citation List

### Non Patent Literature

[Non Patent Literature 1] Noriyuki Iwamuro et al., "Manufacturing Process of SiC / GaN Power Device and Heat-dissipating / Cooling Technique, the first edition, TECHNICAL INFORMATION INSTITUTE CO., LTD, Feb 26, 2010, p 120.

### Summary of Invention

### Technical Problem

However, when a semiconductor device is driven, heat is generated in the semiconductor device due to the driving. In this case, owing to a difference in the thermal expansion coefficient between a semiconductor configuring a semiconductor element and copper, thermal distortion or stress occurs at the joined part of the semiconductor element and a wire. As a result of that, there is a possibility that cracks or the like occur at the joined part and the semiconductor device is broken. Hence, improvement of reliability of a semiconductor device has been demanded.

Therefore, an object of the present invention is to provide a semiconductor device and a wiring substrate capable of realizing high reliability.

### Solution to Problem

A semiconductor device according to an aspect of the present invention includes an insulating substrate, a wiring layer formed on a first main surface of the insulating substrate, and a semiconductor element mounted on the wiring layer. The wiring layer includes a first copper-containing material containing copper and a metal having the thermal expansion coefficient smaller than that of copper and the thermal expansion coefficient of the first copper-containing material is smaller than that of copper.

In this configuration, the wiring layer includes the first copper-containing material having the thermal expansion coefficient smaller than that of copper. Consequently, the thermal expansion coefficient difference between the semiconductor element and the wiring layer is smaller than, for example, that when the wiring layer includes copper. In this case, even when the semiconductor device is driven and heat is generated, the thermal distortion or thermal stress that occurs at the joined part of the semiconductor element and the wiring layer is reduced. As a result of that, it is possible to stably drive the semiconductor device, and therefore, reliability of the semiconductor device is improved.

In an embodiment, the first copper-containing material may be a composite material having a stacked structure in which a first layer including copper and a second layer including the above-mentioned metal are stacked. Further, the first copper-containing material may be an alloy including copper and the above-mentioned metal. When the first copper-containing material is the above-mentioned composite material, the manufacture of the first copper-containing material is easy. When the first copper-containing material is the above-mentioned alloy, it is easier to adjust the thermal expansion coefficient of the first copper-containing material.

When the first copper-containing material is a composite material, the composite material may be configured by stacking a first layer, a second layer, and a third layer in this order. In this case, the second layer is sandwiched by the first layer including copper, and therefore, the surface of the wiring layer includes copper. As a result of that, it is possible to join the wiring layer to an insulating substrate as in the case where the wiring layer includes copper.

In an embodiment, the above-mentioned metal may be molybdenum or tungsten.

In an embodiment, the semiconductor device may include a heat dissipating layer formed on a second main surface on the opposite side of a first main surface of the insulating substrate and a heat sink joined to the insulating substrate via the heat dissipating layer. In this embodiment, the heat dissipating layer may include a second copper-containing material containing copper. Then, the thermal expansion coefficient of the second copper-containing material may be larger than that of the insulating substrate and not more than the thermal expansion coefficient of the heat sink.

The insulating substrate and the heat sink are joined via the heat dissipating layer including the second copper-containing material, and therefore, it is possible to reduce the thermal expansion coefficient difference between the insulating substrate and the heat sink. As a result of that, the thermal stress or the like between the insulating substrate and the heat sink is reduced. Hence, reliability of the semiconductor device is further improved.

In an embodiment, the composition of the second copper-containing material may be the same as that of the first copper-containing material. In this case, the same material is provided on the first main surface and the second main surface of the insulating substrate, and therefore, it is unlikely that the insulating substrate warps.

In an embodiment, a semiconductor configuring the semiconductor element may be a wide band gap semiconductor. A semiconductor device including a semiconductor element using the wide band gap semiconductor is driven at higher temperatures. Because of that, by using the above-mentioned first copper-containing material, it is possible to further improve reliability of the semiconductor device.

Another aspect of the present invention relates to a wiring substrate on which a semiconductor element is mounted. The wiring substrate includes an insulating substrate and a wiring layer which is formed on a main surface of the insulating substrate and on which a semiconductor element is mounted. The wiring layer includes a copper-containing material containing copper and a metal having the thermal expansion coefficient smaller than that of copper and the thermal expansion coefficient of the copper-containing material is smaller than the thermal expansion coefficient of copper.

In this configuration, the wiring layer includes the copper-containing material having the thermal expansion coefficient smaller than that of copper, and therefore, the thermal expansion coefficient difference between the semiconductor element and the wiring layer is smaller than that when the wiring layer includes copper. Hence, even when the semiconductor element is driven and heat is generated, the thermal distortion or thermal stress that occurs between the semiconductor element and the wiring layer is reduced. As a result of that, it is possible to stably drive the semiconductor element mounted on the wiring substrate, and therefore, reliability of a device including the wiring substrate and the semiconductor element is improved.

### Advantageous Effects of Invention

The present invention provides a semiconductor device capable of realizing high reliability and a wiring substrate on which a semiconductor element is mounted.

### Brief Description of Drawings

[Fig. 1] Fig. 1 is a section view showing an outline of a configuration of a semiconductor device according to an embodiment.
[Fig. 2] Fig. 2 is a perspective view of an example of a wiring substrate that the semiconductor device shown in Fig. 1 includes.
[Fig. 3] Fig. 3 is a schematic diagram showing an example of a configuration of a wiring layer that the wiring substrate shown in Fig. 2 includes.

### Description of Embodiments

Hereinafter, embodiments of the present invention are explained with reference to the drawings. In the explanation of the drawings, the same symbol is attached to the same component and duplicated explanation is omitted. The ratio of dimension in the drawing does not necessarily agree with that in the explanation. In the explanation, terms indicating directions, such as "upper" and "lower," are convenient terms based on the state shown schematically.

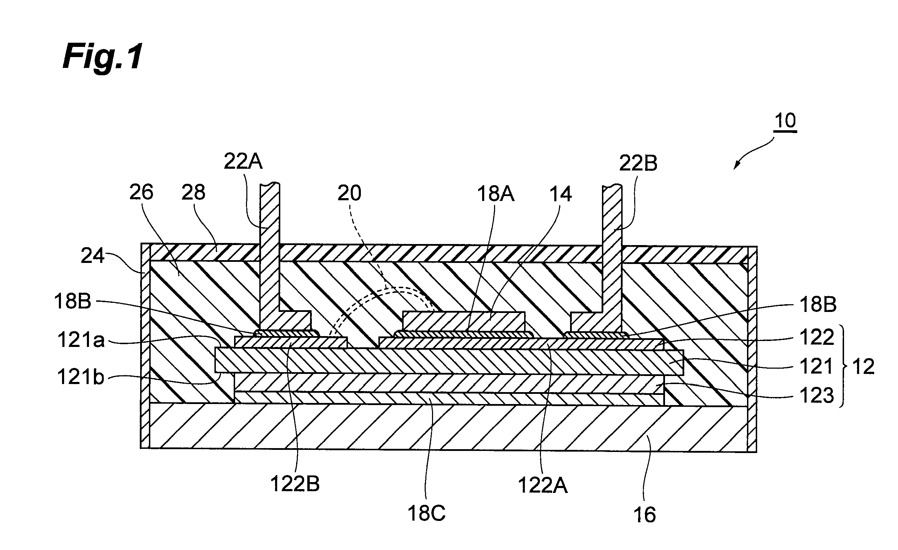

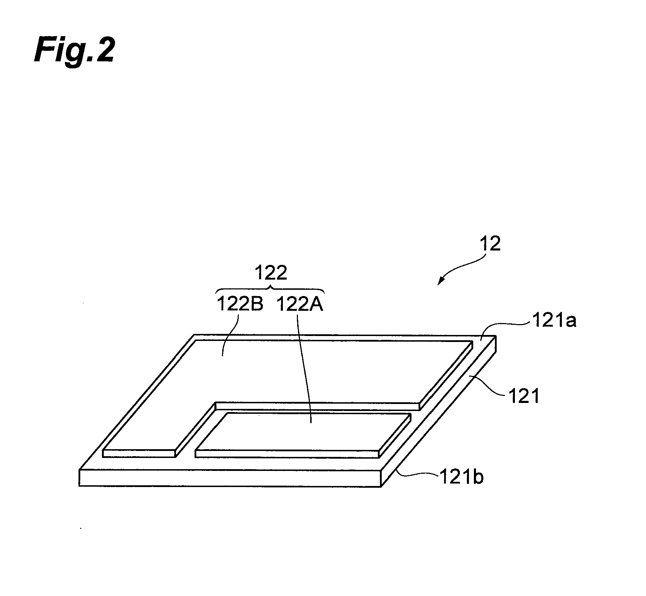

Fig. 1 is a section view showing an outline of a configuration of a semiconductor device according to an embodiment. Fig. 2 is a perspective view of a wiring substrate that the semiconductor device shown in Fig. 1 includes. A semiconductor device 10 is a semiconductor module including a wiring substrate 12, a semiconductor element 14 mounted on the wiring substrate 12, and a heat sink 16 arranged on the opposite side of the semiconductor element 14 with respect to the wiring substrate 12. The semiconductor device 10 may be, for example, a power semiconductor device used for a power source or the like.

Examples of the semiconductor element 14 include an insulated field effect transistor (MOSFET), a junction field effect transistor, and a bipolar transistor. Examples of MOSFET may include a vertical MOSFET and a lateral MOSFET. Examples of a semiconductor constituting the semiconductor element 14 include a wide band gap semiconductor, such as SiC and GaN, and Si.

As shown in Fig. 1 and Fig. 2, the wiring substrate 12 has an insulating substrate 121 and a wiring layer 122 provided on a surface (first main surface) 121 a of the insulating substrate 121. The wiring layer 122 may be joined to the insulating substrate 121 via a brazing filler metal or the like or directly. Examples of the shape of the insulating substrate 121 in a planar view may include a rectangle and a square. In an embodiment, an example of the material of the insulating substrate 121 is alumina (thermal expansion coefficient: about 7.0 × 10⁻⁶ / K). The wiring layer 122 includes a plurality of electrically conductive wiring regions (hereinafter referred to simply as wire) 122A and 122B insulated from each other. The plurality of the wires 122A and 122B is arranged in a predetermined wiring pattern. Fig. 1 illustrates the two wires 122A and 122B, but, the number of wires is not limited to two.

The semiconductor element 14 is mounted on the wire 122A configuring part of the wiring layer 122. The semiconductor element 14 is soldered to the wire 122A. That is, between the semiconductor element 14 and the wiring layer 122, layered solder 18A as an adhesive layer is interposed. An example of the solder 18A is Sn-Ag-Cu based solder. When the semiconductor element 14 is a vertical MOSFET, the lower part of the semiconductor element 14 is a drain electrode. Consequently, by fixing the semiconductor element 14 onto the wire 122A by utilizing the solder 18A, the wire 122A and the semiconductor element 14 are connected electrically. An electrode provided at the upper part of the semiconductor element 14 is electrically connected to the wire 122B via a wire 20, such as an aluminum wire. When the semiconductor element 14 has no electrode at the lower part, it is possible to electrically connect the semiconductor element 14 and the wire 122A by wire-boding an electrode, which is provided at the upper part of the semiconductor element 14 separately from the electrode connected to the wire 122B, and the wire 122A.

By fixing terminals 22A and 22B onto the wires 122A and 122B, respectively, using solder 18B or the like, it is possible to connect the semiconductor element 14 to the outside by utilizing the terminals 22A and 22B. An example of the solder 18B is Sn-Ag-Cu based solder. Here, an example of a connection relationship between the semiconductor element 14 and the wiring layer 122 is shown, but, it is only required for the semiconductor element 14 to be electrically connected with the wiring layer 122 by utilizing the terminals 22A and 22B or the like connected to the wiring layer 122 so as to allow the semiconductor element 14 to operate.

The wiring layer 122 is composed of a copper-containing material (first copper-containing material) containing copper and having the thermal expansion coefficient smaller than that of copper. In an embodiment, the thermal expansion coefficient of the copper-containing material may be smaller than that of copper and not less than the thermal expansion coefficient of the semiconductor configuring the semiconductor element 14. The copper-containing material contains copper (thermal expansion coefficient: about 16.8 × 10⁻⁶ / K) and another metal having the thermal expansion coefficient smaller than that of copper. Such a copper-containing material may be a composite material or alloy. Examples of another metal different from copper and included in the copper-containing material include molybdenum (thermal expansion coefficient: about 5.1 × 10⁻⁶ / K) and tungsten (thermal expansion coefficient: about 4.5 × 10⁻⁶ / K). It is only required for the copper-containing material to contain one kind of another metal described above different from copper as long as the thermal expansion coefficient of the metal is smaller than that of copper. Consequently, the copper-containing material may contain two or more kinds of metal different from copper.

When the copper-containing material is a composite material of copper and another metal having the thermal expansion coefficient smaller than that of copper, the composite material may have a stacked structure in which a layer (first layer) composed of copper and a layer (second layer) composed of another metal described above are stacked.

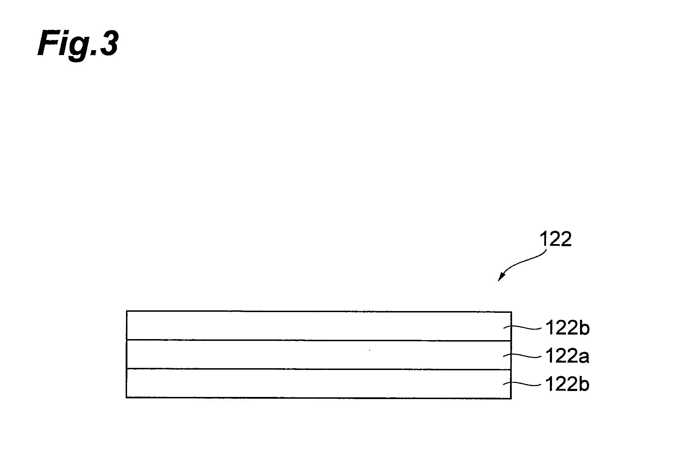

Fig. 3 is a schematic diagram showing an example of a wiring layer when the copper-containing material is a composite material. In the embodiment shown in Fig. 3, the wiring layer 122 is composed of a composite material having a three-layer structure in which an intermediate layer (second layer) 122a composed of a metal having the thermal expansion coefficient smaller than that of copper is sandwiched by surface layers (first layers) 122b and 122b composed of copper. In the embodiment shown in Fig. 3, the surface facing the insulating substrate 121 is composed of copper. In this case, it is possible to directly join the wiring layer 122 to the insulating substrate 121, for example, as in the case of the DBC (Direct Bonding Copper) substrate. The layer structure of the composite material may be a two-layer structure or four- or more-layer structure. When the composite material has three or more layers, the material constituting each layer may be different from one another.

An example of the composite material as the copper-containing material constituting the wiring layer 122 is a Cu-Mo-Cu composite material in which the intermediate layer 22a shown in Fig. 3 includes molybdenum (Mo).

An example of the copper-containing material as the alloy of copper and another metal is a Cu-W alloy in which the another metal is tungsten (W).

The wiring substrate 12 may include a heat dissipating layer 123 on a back surface (second main surface) 121b on the opposite side of the surface 12a of the insulating substrate 121. The heat dissipating layer 123 may be formed so as to cover the entire back surface 121b. The heat dissipating layer 123 may be joined to the back surface 121b via a brazing filler metal or the like or directly as in the case of the wiring layer 122. When the heat dissipating layer 123 is possessed in this manner, the heat dissipating layer 123 may be composed of a copper-containing material (second copper-containing material) containing copper. The thermal expansion coefficient of the copper-containing material constituting the heat dissipating layer 123 is larger than the thermal expansion coefficient of the insulating substrate 121 and not more than that of the heat sink 16.

As will be described later, as an example, when the heat sink 16 is composed of copper, the copper-containing material constituting the heat dissipating layer 123 may be copper. However, the composition of the copper-containing material constituting the heat dissipating layer 123 may be the same as the composition of the copper-containing material constituting the wiring layer 122. That is, the copper-containing material constituting the heat dissipating layer 123 may be the composite material or alloy illustrated as the copper-containing material constituting the wiring layer 122. When the copper-containing material constituting the heat dissipating layer 123 and the copper-containing material constituting the wiring layer 122 are the same, it is unlikely that the thermal expansion coefficient difference occurs between the surface 121 a side and the back surface 121b side of the insulating substrate 121, and therefore, it is unlikely that the wiring substrate 12 warps.

The heat sink 16 is a metal plate. It is sufficient for the heat sink 16 to be composed of a metal having high thermal conductivity. An example of the metal constituting the heat sink 16 is copper. The shapes in a planar view of the heat sink 16 include a rectangle and a square. In an embodiment, the heat sink 16 may be joined to the opposite side of the surface of the wiring substrate 12 via solder 18C. An example of the solder 18C is Sn-Ag-Cu based solder. When the heat dissipating layer 123 is formed on the back surface of the wiring substrate 12, as shown in Fig. 1, between the insulating substrate 121 and the heat sink 16, the heat dissipating layer 123 and the layered solder 18C may be sandwiched in this order from the side of the insulating substrate 121.

As shown in Fig. 1, the semiconductor device 10 may have a resin case 24 in the shape of a frame that surrounds the heat sink 16. Examples of the material of the resin case 24 include engineering plastic, such as polybutylene terephthalate (PBT) and polyphenylene sulfide resin (PPS). The resin case 24 is fixed on the outer edge part of the heat sink 16. Into the inside of the resin case 24, for example, silicone gel 26 may be injected for stress relaxation. Further, as shown in Fig. 1, the wiring substrate 12, the semiconductor element 14, or the like, embedded within the silicone gel 26 may be further sealed hermetically by a thermoplastic resin 28, such as an epoxy resin. It may also be possible to embed the wiring substrate 12, the semiconductor element 14, or the like, directly by the thermoplastic resin 28 without via the silicone gel 26.

In the semiconductor device 10 with the above-mentioned configuration, the difference between the thermal expansion coefficient of the semiconductor element 14 and the thermal expansion coefficient of the wiring layer 122 is small, and therefore, it is possible to improve reliability of the semiconductor device 10. This point is explained with a comparison with the case where the wire of the wiring substrate is a copper wire composed of copper.

Examples of the constituent material of the semiconductor element used in the semiconductor device include SiC, GaN, and Si. The thermal expansion coefficient of SiC is about 4.2 × 10⁻⁶ / K, the thermal expansion coefficient of GaN is about 5.6 × 10⁻⁶ / K, and the thermal expansion coefficient of Si is about 3.0 × 10⁻⁶ / K. On the other hand, the thermal expansion coefficient of copper is about 16.8 × 10⁻⁶ / K. Consequently, if the wire is a copper wire, there arises a large thermal expansion coefficient difference between the semiconductor element and the wire. In this case, when the semiconductor device is driven and heat is generated, a large stress is exerted on the joined part (for example, soldered part) between the semiconductor element and the wire by the above-mentioned thermal expansion coefficient difference and there is a possibility that cracks occur at the joined part and the semiconductor device is broken.

In contrast to this, in the semiconductor device 10, the wiring layer 122 is composed of the copper-containing material containing copper and another metal having the thermal expansion coefficient smaller than that of copper, and therefore, the thermal expansion coefficient of the wiring layer 122 is smaller than that of copper. Because of that, the thermal expansion coefficient difference between the semiconductor element 14 and the wiring layer 122 is reduced. When the thermal expansion coefficient difference is reduced as described above, even when the semiconductor device 10 is driven and heat is generated, the stress that acts on the joined part of the semiconductor element 14 and the wiring layer 122 is reduced, and therefore, it is unlikely that cracks or the like occur at the joined part. Because of that, reliability of the semiconductor device 10 is improved. In other words, by using the wiring substrate 12 including the wiring layer 122, it is possible to realize high reliability of the semiconductor device 10.

Further, the thermal conductivity of copper contained in the copper-containing material is higher than the thermal conductivity of, for example, tungsten and molybdenum. Consequently, heat dissipatability is more excellent than when the wiring layer includes, for example, only tungsten and molybdenum because the wiring layer 122 is composed of the copper-containing material. Because of that, it is likely that the stress caused by the thermal expansion coefficient difference is further reduced.

When the wiring layer 122 is composed of a composite material having a stacked structure as shown in Fig. 3, manufacture of the copper-containing material is easy. When the surface layer 122b of the three-layer structure is composed of copper as shown in Fig, 3, the wiring layer 122 may be fixed on the insulating substrate 121 as in the case of the DBC substrate.

As described previously, the copper-containing material constituting the wiring layer 122 may be an alloy (for example, Cu-W alloy) of copper and another metal having the thermal expansion coefficient smaller than that of copper. In the case of such an alloy, the thermal expansion coefficient may be adjusted by adjusting the content percentage of another metal. Because of that, the adjustment of the thermal expansion coefficient of the copper-containing material is easy.

Further, in the embodiment in which the wiring substrate 12 includes the heat dissipating layer 123 and the heat dissipating layer 123 is composed of the copper-containing material having the thermal expansion coefficient larger than the thermal expansion coefficient of the insulating substrate 121 and not more than the thermal expansion coefficient of the heat sink 16, the thermal expansion coefficient difference between the heat dissipating layer 123 and the heat sink 16 is also small. As a result of that, even when the semiconductor device 10 is driven and heat is generated, it is unlikely that breakage, such as cracks, occurs at the joined part (part of the layered solder 18C in Fig. 1) between the heat dissipating layer 123 and the heat sink 16. Consequently, reliability of the semiconductor device 10 is further improved. Furthermore, as in the case of the wiring layer 122, when the heat dissipating layer 123 composed of a material containing copper, such as the copper-containing material, heat dissipatability is more excellent than when the heat dissipating layer composed of, for example, only tungsten and molybdenum. Hence, it is likely that the stress caused by the thermal expansion coefficient difference is further reduced.

When the wide band gap semiconductor, such as SiC and GaN, is adopted as the semiconductor constituting the semiconductor element 14, the semiconductor element 14 may be driven at temperatures higher than those when the semiconductor element is consisted of Si. In this configuration, it is likely that the temperature rises to high temperature when the semiconductor device 10 is driven. Hence, the reduction of the thermal expansion coefficient difference by using the copper-containing material as the material of the wiring layer 122 as described above is particularly effective from the standpoint of improving reliability of the semiconductor device 10.

The embodiments of the present invention are explained as above, but, the present invention is not limited to the above-mentioned embodiments and there can be various modifications in the scope not deviating from the gist of the invention. For example, the semiconductor device as a semiconductor module may be a semiconductor device as a unit including the wiring substrate 12 and the semiconductor element 14.

### Reference Signs List

10... semiconductor device; 12... wiring substrate; 14... semiconductor element; 16... heat sink; 121... insulating substrate; 121 a... surface (first main surface); 121b...back surface (second main surface); 122... wiring layer; 123...heat dissipating layer.

## Claims

1. A semiconductor device comprising:
an insulating substrate;
a wiring layer formed on a first main surface of the insulating substrate; and
a semiconductor element mounted on the wiring layer, wherein
the wiring layer composed of a first copper-containing material containing copper and a metal having the thermal expansion coefficient smaller than that of copper, and
the thermal expansion coefficient of the first copper-containing material is smaller than the thermal expansion coefficient of copper.

2. The semiconductor device according to claim 1, wherein
the first copper-containing material is a composite material having a stacked structure in which a first layer composed of copper and a second layer composed of the metal are stacked or an alloy including copper and the metal.

3. The semiconductor device according to claim 2, wherein
the composite material is configured by stacking the first layer, the second layer, and the first layer in this order.

4. The semiconductor device according to any one of claims 1 to 3, wherein
the metal is molybdenum or tungsten.

5. The semiconductor device according to any one of claims 1 to 4, comprising:
a heat dissipating layer formed on a second main surface on the opposite side of the first main surface of the insulating substrate; and
a heat sink joined to the insulating substrate via the heat dissipating layer, wherein
the heat dissipating layer is composed of a second copper-containing material containing copper, and
the thermal expansion coefficient of the second copper-containing material is larger than the thermal expansion coefficient of the insulating substrate and not more than the thermal expansion coefficient of the heat sink.

6. The semiconductor device according to claim 5, wherein
the composition of the second copper-containing material is the same as the composition of the first copper-containing material.

7. The semiconductor device according to any one of claims 1 to 6, wherein
a semiconductor constituting the semiconductor element is a wide band gap semiconductor.

8. A wiring substrate on which a semiconductor element is mounted, comprising:
an insulating substrate; and
a wiring layer which is formed on a main surface of the insulating substrate and on which the semiconductor element is mounted, wherein
the wiring layer is composed of a copper-containing material containing copper and a metal having the thermal expansion coefficient smaller than that of copper, and
the thermal expansion coefficient of the copper-containing material is smaller than the thermal expansion coefficient of copper.
